# EUROPEAN PATENT APPLICATION

(11) **EP 3 316 154 A1**
(43) Date of publication of application: **02.05.2018**
(21) Application number: 17178804.5
(22) Date of filing: 29.06.2017
(51) Int. Cl.: G06F 17/50

(54) **A COMPUTER-IMPLEMENTED METHOD OF DETECTING A GROUP OF GEOMETRIC FEATURES IN A GEOMETRIC MODEL**

(30) Priority: 25.10.2016 GB 201618033; 25.10.2016 DE 102016221002
(71) Applicant: Fujitsu Limited, Kawasaki-shi, Kanagawa 211-8588 (JP)
(72) Inventor: GEORGESCU, Serban, London, Kanagawa W5 3JY (GB); FURUYA, Sachiko, Kawasaki-shi, Kanagawa 211-8588 (JP); CHOW, Peter, Gillingham, Kent ME7 3AH (GB); HAYASHI, Hirooki, Kawasaki-shi, Kanagawa 211-8588 (JP)
(74) Representative: Haseltine Lake LLP

(57) **Abstract**

A computer-implemented method of detecting a group of geometric features in a geometric model, the method comprising: accessing a computer file including a geometric model of an object with a group of geometric elements comprising at least a first and a second geometric element in a defined spatial relationship; accessing detection results detecting any instances of each of the geometric elements; checking that each instance of each geometric element has the defined spatial relationship with an instance of each of the other geometric elements; when an instance of a geometric element does not have the defined spatial relationship with an instance of each of the other geometric elements, rejecting that instance of a geometric element as not belonging to the group.

## Description

The present invention relates to computer-aided design and engineering. In particular it relates to detection of groups of features in a model created of an object in a computer environment. Once the groups of features have been detected they may, for example, be modified or removed, in order to render that model more suitable for analysis by simplification. Then CFD (Computational Fluid Dynamics) analysis may be carried out on the simplified model to model fluid flow and potentially heat flow around the model.

The problem of detecting parts or subparts in a geometric or Computer Aided Design, CAD, model has been tackled in many studies. Based on the type of approach being taken, the detection methods may be split into two categories:
1. Expert system type
2. Machine learning type

An example of an expert type system is given in prior art document [1] Chow et al, Automatic Detection of Geometric Features in CAD Models by Characteristics, Proceedings of CAD'14, 2014, 201-203, where special characteristics of subparts are used for detection. The advantage of such a system is that expert knowledge is explicitly incorporated in the detection process and the reason why certain parts are detected while others are not may be very easily understood. On the other hand, designing an accurate expert system takes tremendous effort, especially for complex shapes such as screws.

Machine learning (or ML) type systems do not need to be explicitly programed to detect certain object - they may automatically learn from examples. An example of such a system is given in prior art document. A deep learning approach to the classification of 3D CAD models, J Zhejiang Univ-Sci C (Comput & Electron) 2014 15(2):91-106, where neural networks are used to detect various CAD parts. However, such systems are usually prone to false positives and/or false negatives, since it often happens that other parts or subparts may look very similar to the ones being searched. In a screw detection example, a shaft part may sometimes look similar to a screw to the extent that it is difficult for even a human to tell them apart by looking at the geometry alone.

Regardless of the approach taken, there is a need to improve the detection accuracy for such parts to decrease the amount of human labor required to complement the detection.

Hence it is desirable to create a system that increases the reliability of the automatic detection of CAD parts and subparts.

According to an embodiment of one aspect of the invention there is provided a computer-implemented method of detecting a group of geometric features in a geometric model, the method comprising:
accessing a computer file including a geometric model of an object with a group of geometric elements comprising at least a first and a second geometric element in a defined spatial relationship;
accessing detection results detecting any instances of each of the geometric elements; checking that each instance of each geometric element has the defined spatial relationship with an instance of each of the other geometric elements;
when an instance of a geometric element does not have the defined spatial relationship with an instance of each of the other geometric elements, rejecting that instance of a geometric element as not belonging to the group.

Correspondingly, an instance of a geometric element may be confirmed if it has the defined spatial relationship with other geometric element in a pair (and if it has the defined spatial relationship with each other geometric element if there are more than two elements in the group). Detecting a pair (if there are two elements), a triplet (a group of three elements) or a group of more than three elements together is useful in the elimination of "false positives" when detecting geometric elements.

Any suitable spatial relationship maybe provided, particularly indicating a proximity of the elements. The defined spatial relationship may be that the distance between the geometric elements is below a threshold distance, and the threshold distance may be a zero distance.

The distance between the geometrical elements may be calculated, for example, by the distance between the closest faces, or between the centres of the geometrical elements, or by the distance between the bounding boxes of the geometrical elements.

The group of geometric elements must contain at least two (a pair of) elements or could be a group of three elements. The invention is most useful when more than one group of the same elements (group of a particular classification) is present in the model.

Each group classification may include groups of certain elements. In some embodiments, the group of elements comprises a screw element and one or more other elements, and is classified as comprising, for example, a screw and a boss, or a screw and a nut, or a screw and a washer. Alternatively, the group of elements may comprise a screw and two or more other elements, and be classified as comprising, for example, a screw and a washer and a nut.

More than one classification of a group of elements may be detected in a geometric model by detecting groups of each classification, for example by detecting the groups of different classifications at the same time or in turn.

There may be a detection stage in which the instances of the at least first and second geometric elements (or of all the geometric elements present in the group classifications) are detected in parallel.

The method may further include segmentation of the geometric model to detect subparts (portions of a part) which potentially comprise an element of the group of elements.

For example, subparts may be detected by extracting faces below a predetermined size and combining the extracted faces into a possible element if they have an edge in common.

Possible elements with less than a threshold minimum number of faces and/or more than a threshold maximum number of faces may be disregarded.

The method may further comprise detecting penetration of a male element within a female element in the group, by detection of a surface of the male element and a surface of the female element which overlap and by computing the overlapping distance.

This overlapping distance may be used to calculate a number of threads of interpenetration and to generate an alarm if the number of threads is less than a safe-threading threshold. For example, the alarm may be a pop-up warning displayed on a screen or other user warning.

The geometric model of the computer file may comprise triangulated data with face information, or the method may include production of triangulated data with face information (from a model that does not immediately present such information).

The geometric model may represent an assembly of physical (three-dimensional) parts, for example in an assembly of parts. The assembly may be a manufactured product.

According to an embodiment of a second aspect of the invention, there is provided a computer apparatus to detect a group of geometric features in a geometric model, the computer apparatus comprising:
a processor and a memory storing instructions for execution by the processor, wherein the processor is configured by the instructions to:
   access a computer file including a geometric model of an object with a group of geometric elements comprising at least a first and a second geometric element in a defined spatial relationship;
   access detection results detecting any instances of each of the geometric elements;
   check that each instance of each geometric element has the defined spatial relationship with an instance of each of the other geometric elements; and
   when an instance of a geometric element does not have the defined spatial relationship with an instance of each of the other geometric elements, to reject that instance of a geometric element as not belonging to the group.

According to an embodiment of a third aspect of the invention, there is provided a computer program, which when executed carries out a computer-implemented method of detecting a group of geometric features in a geometric model, the method comprising:
accessing a computer file including a geometric model of an object with a group of geometric elements comprising at least a first and a second geometric element in a defined spatial relationship;
accessing detection results detecting any instances of each of the geometric elements; checking that each instance of each geometric element has the defined spatial relationship with an instance of each of the other geometric elements;
when an instance of a geometric element does not have the defined spatial relationship with an instance of each of the other geometric elements, rejecting that instance of a geometric element as not belonging to the group.

An apparatus or computer program according to preferred embodiments of the present invention may comprise any combination of the method aspects. Methods or computer programs according to further embodiments may be described as computer-implemented in that they require processing and memory capability.

The apparatus according to preferred embodiments is described as configured or arranged to, or simply "to" carry out certain functions. This configuration or arrangement could be by use of hardware or middleware or any other suitable system. In preferred embodiments, the configuration or arrangement is by software.

Thus according to one aspect there is provided a program which, when loaded onto at least one computer configures the computer to become the apparatus according to any of the preceding apparatus definitions or any combination thereof.

According to a further aspect there is provided a program which when loaded onto the at least one computer configures the at least one computer to carry out the method steps according to any of the preceding method definitions or any combination thereof.

In general the computer may comprise the elements listed as being configured or arranged to provide the functions defined. For example this computer may include memory, processing, and a network interface.

The invention may be implemented in digital electronic circuitry, or in computer hardware, firmware, software, or in combinations of them. The invention may be implemented as a computer program or computer program product, i.e., a computer program tangibly embodied in a non-transitory information carrier, e.g., in a machine-readable storage device, or in a propagated signal, for execution by, or to control the operation of, one or more hardware modules.

A computer program may be in the form of a stand-alone program, a computer program portion or more than one computer program and may be written in any form of programming language, including compiled or interpreted languages, and it may be deployed in any form, including as a stand-alone program or as a module, component, subroutine, or other unit suitable for use in a data processing environment. A computer program may be deployed to be executed on one module or on multiple modules at one site or distributed across multiple sites and interconnected by a communication network.

Method steps of the invention may be performed by one or more programmable processors executing a computer program to perform functions of the invention by operating on input data and generating output. Apparatus of the invention may be implemented as programmed hardware or as special purpose logic circuitry, including e.g., an FPGA (field programmable gate array) or an ASIC (application-specific integrated circuit).

Processors suitable for the execution of a computer program include, by way of example, both general and special purpose microprocessors, and any one or more processors of any kind of digital computer. Generally, a processor will receive instructions and data from a read-only memory or a random access memory or both. The essential elements of a computer are a processor for executing instructions coupled to one or more memory devices for storing instructions and data.

The invention is described in terms of particular embodiments. Other embodiments are within the scope of the following claims. For example, the steps of the invention may be performed in a different order and still achieve desirable results.

Elements of the invention have been described using the terms "memory", "processor", etc. The skilled person will appreciate that such terms and their equivalents may refer to parts of the system that are spatially separate but combine to serve the function defined. Equally, the same physical parts of the system may provide two or more of the functions defined.

For example, separately defined means may be implemented using the same memory and/or processor as appropriate.

Preferred features of the present invention will now be described, purely by way of example, with references to the accompanying drawings, in which:-
Figure 1 is a flow chart of a method in a general embodiment;
Figure 2 is a block diagram of main system components in a general embodiment of the invention
Figure 3 is a diagram of a high-level layout of an invention embodiment;
Figure 4 is an example of a pair of elements in close proximity;
Figure 5 is a flowchart of a paired detection method;
Figure 6 is a flowchart of a segmentation method for detecting subparts of a part;
Figure 7 is a perspective view of part of a model, including geometric elements which are to be detected;
Figure 8 is a perspective view of a model of a screw;
Figure 9 is a sectional view of a screw and a boss demonstrating the number of threads inside the boss; and
Figure 10 is a flowchart for computing the number of threads inside the boss.

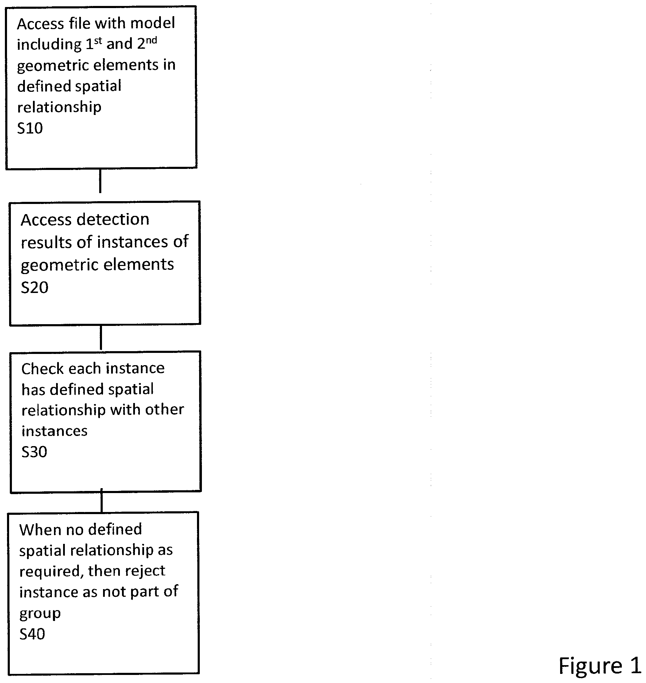

Figure 1 is a flow chart demonstrating a general embodiment of the invention. The computer-implemented method detects a group of geometric features in a geometric model. Firstly, the method accesses a computer file including a geometric model of an object with a group of geometric elements comprising at least a first and a second geometric element in a defined spatial relationship. This may be a CAD file in any available format. The method also accesses (or indeed provides) detection results detecting any instances of each of the geometric elements. Using this data, the method checks that each instance of each geometric element has the defined spatial relationship with an instance of each of the other geometric elements. For example, this may be by comparison of bounding boxes (boxes which surround each of the objects) or centres of the objects. When an instance of a geometric element does not have the defined spatial relationship with an instance of the other geometric element in a pair or each of the other geometric elements in a group of more than two elements, that instance of a geometric element is rejected as not belonging to the group. Of course, the rejected instance may belong to another group, or it may not belong to any group.

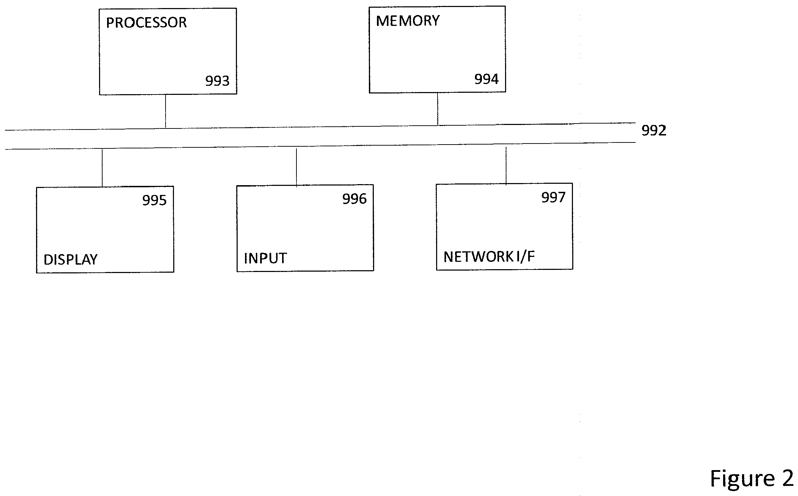

Figure 2 is a block diagram of a computing device, such as a hardware data storage server which embodies the present invention, and which may be used to implement a method of improved part detection as detailed herein. The computing device comprises hardware parts such as a processor 993, and memory, 994. Optionally, the computing device also includes a network interface 997 for communication with other computing devices, for example with other computing devices of invention embodiments.

For example, an embodiment may be composed of a network of such computing devices. Optionally, the computing device also includes one or more input mechanisms such as keyboard and mouse 996, and a display unit such as one or more monitors 995. The components are connectable to one another via a bus 992.

The memory 994 may include a computer readable medium, which term may refer to a single medium or multiple media (e.g., a centralized or distributed database and/or associated caches and servers) configured to carry computer-executable instructions or have data structures stored thereon. Computer-executable instructions may include, for example, instructions and data accessible by and causing a general purpose computer, special purpose computer, or special purpose processing device (e.g., one or more processors) to perform one or more functions or operations. Thus, the term "computer-readable storage medium" may also include any medium that is capable of storing, encoding or carrying a set of instructions for execution by the machine and that cause the machine to perform any one or more of the methods of the present disclosure. The term "computer-readable storage medium" may accordingly be taken to include, but not be limited to, solid-state memories, optical media and magnetic media. By way of example, and not limitation, such computer-readable media may include non-transitory computer-readable storage media, including Random Access Memory (RAM), Read-Only Memory (ROM), Electrically Erasable Programmable Read-Only Memory (EEPROM), Compact Disc Read-Only Memory (CD-ROM) or other optical disk storage, magnetic disk storage or other magnetic storage devices, flash memory devices (e.g., solid state memory devices).

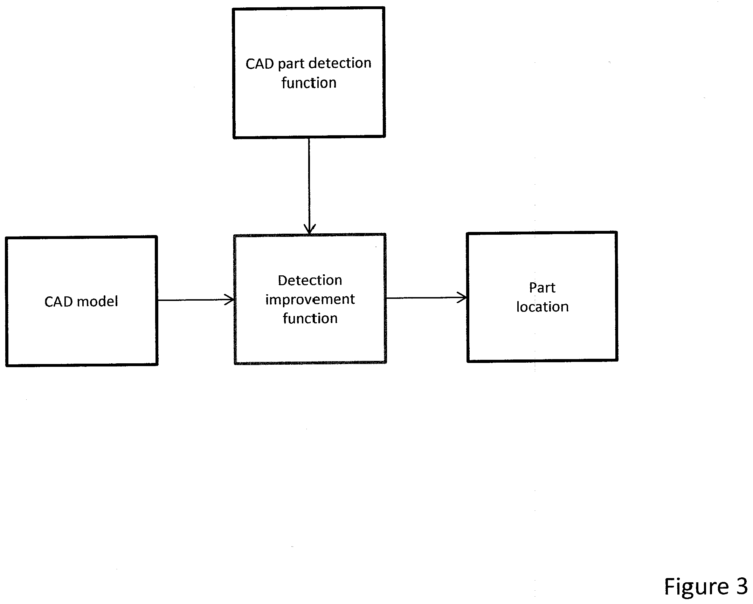

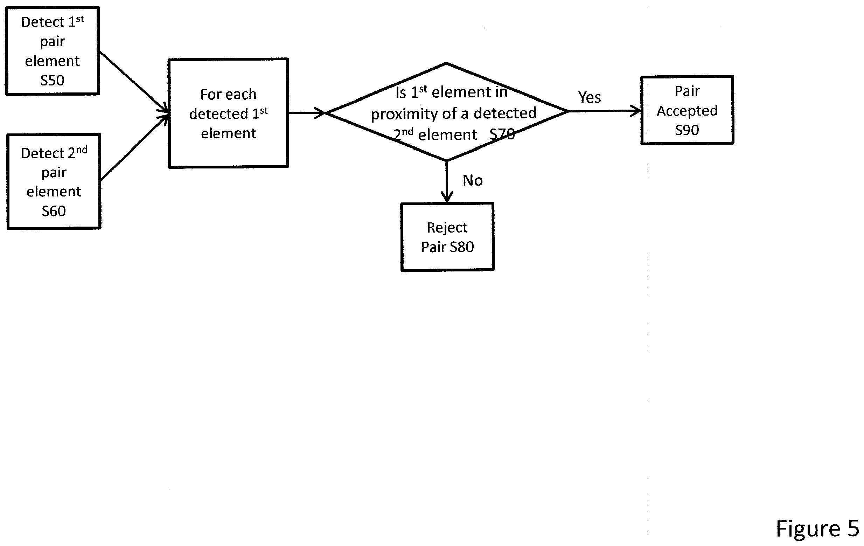

The processor 993 is configured to control the computing device and execute processing operations, for example executing code stored in the memory to implement the various different functions described here and in the claims and in figures 1 and 5, such as the steps in figure 1 of accessing the model including first and second geometric elements in a defined spatial relationship, accessing detection results of instances of the geometric elements, checking for a defined spatial relationship between the instances and rejecting the instance if the defined spatial relationship is not required. Hence the processor implements the detection improvement function shown in figure 3. It may implement a specific method of pair detection using proximity of two elements as shown in figure 5.

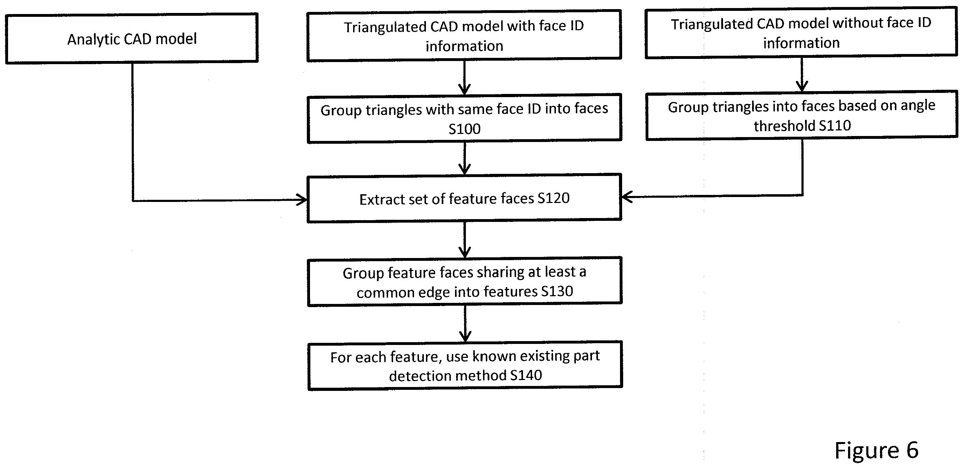

The processor may also implement any pre-processing of triangulated CAD models and then processing of all CAD models as detailed in figure 6 to extract a set of feature faces, group feature faces into features using a common edge methodology and then to use a known part detection method for each feature.

The memory 994 stores data being read and written by the processor 993. For example, the memory may store the geometric model, interim results of processing such as extracted feature faces and features and detection of results of instances of the geometric elements. It may also store final results such as detected groups of parts.

As referred to herein, a processor may include one or more general-purpose processing devices such as a microprocessor, central processing unit, or the like. The processor may include a complex instruction set computing (CISC) microprocessor, reduced instruction set computing (RISC) microprocessor, very long instruction word (VLIW) microprocessor, or a processor implementing other instruction sets or processors implementing a combination of instruction sets. The processor may also include one or more special-purpose processing devices such as an application specific integrated circuit (ASIC), a field programmable gate array (FPGA), a digital signal processor (DSP), network processor, or the like. In one or more embodiments, a processor is configured to execute instructions for performing the operations and steps discussed herein.

The display unit 997 may display a representation of data stored by the computing device and may also display a cursor and dialog boxes and screens enabling interaction between a user and the programs and data stored on the computing device. The input mechanisms 996 may enable a user to input data and instructions to the computing device.

The network interface (network I/F) 997 may be connected to a network, such as the Internet, and is connectable to other such computing devices via the network. The network I/F 997 may control data input/output from/to other apparatus via the network. Other peripheral devices such as microphone, speakers, printer, power supply unit, fan, case, scanner, trackerball etc. may be included in the computing device.

Processing instructions may be stored on a portion of the memory 994, the processor 993 may execute the processing instructions, and a portion of the memory 994 may store data during the execution of the processing instructions, for example to detect a geometric element or to check for the spatial relationship or to reject an instance of an element/confirm an instance of an element as part of a group. The detected groups and rejected instances may be stored on the memory 994 and/or on a connected storage unit, for manual processing of the rejected instances, for example, or for further automatic processing.

Methods embodying the present invention (including model simplification and CFD analysis) may be carried out on a computing device such as that illustrated in Figure 2. Such a computing device need not have every component illustrated in Figure 2, and may be composed of a subset of those components. A method embodying the present invention may be carried out by a single computing device in communication with one or more data storage servers via a network. The computing device may be a data storage itself storing the CAD model, the detected groups of features and any amended CAD model, as well as any CFD simulation results.

A method embodying the present invention may be carried out by a plurality of computing devices operating in cooperation with one another. One or more of the plurality of computing devices may be a data storage server storing at least a portion of the CAD model, the detected groups of features and any amended CAD model.

Embodiments of this invention may be applied to certain parts, such as screws, that are known to have a pair (for a screw, this is the boss) where the two are always in close proximity, and thus have a defined spatial relationship.

Embodiments of the invention may also be applied where there are parts belonging to two different classifications of pair (a screw and a boss, or a screw and a nut).

Furthermore, embodiments of the invention may be applied where there are three parts that form a "triplet" of parts, such as a screw and a washer and a nut, or a screw and a washer and a bolt.

A system according to invention embodiments takes as input a CAD model. The CAD model may in general be an assembly of many components (e.g., a few hundred for a laptop computer), stored in either an analytic boundary representation form such as STEP (Standard for the Exchange of Product model data), IGES (Initial Graphics Exchange Specification) or ACIS formats or a triangulated from such as STL (STereoLithography) or VRML (Virtual Reality Modeling Language) formats.

A high-level layout of an invention embodiment is shown in Figure 3. Here, the CAD model is read by the "detection improvement function". This function improves the quality of detection for an already existing CAD part detection function appropriate for the type of CAD part that is being detected. The improvement may be generic in the sense that it uses the CAD part detection function as a black-box. However, for efficiency reasons, it is preferable that the existing CAD part detection function provides a way of adjusting the detection threshold (that is, the balance between the likelihood of generating false positives and false negatives).

When the detection is based on a machine learning algorithm, and a database of positive and negative examples has been provided, then classification of an unknown shape could be by finding the most similar N shapes and taking the majority class. In this case there could be a 50% threshold. To err on the positive side, the positive class could be assigned, for example, if not 50% but only 30% of the most similar shapes are positives.

Preferably, use of the invention may allow more false positives at the detection phase because they are eliminated at the improvement or group detection phase, and thus embodiments may also simplify processing at the detection phase. If there is already a detection method, then it could be plugged into the paired detection method to increase its accuracy. If a new detection function is being developed, there could be less effort put into the development, and reliance on paired detection to fill in the gaps.

The method of invention embodiments may be seen as a drop-in replacement for the normal method, improving the results and carrying out the detection. In this case, the same user will use it at the same location (physically and in the implementing code), the only difference being that it is expected to be more accurate. Alternatively, the method of invention embodiments may take detection function results and improve on those, according to the black box methodology mentioned above.

However, this method may actually accomplish more than simple detection of one part; for example, in the case of screw-boss detection it may detect the boss and its spatial relationship to the screw as well. Hence it may be used possibly by the same user or someone else for a different purpose, for example to compute the amount of penetration of screws in the corresponding bosses.

### Paired or grouped detection

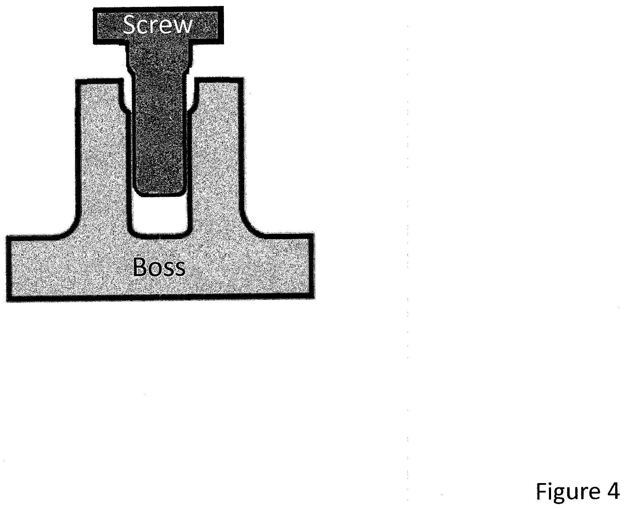

One idea of invention embodiments is to increase the accuracy of an existing detection process by using a method of "paired detection". The "pair" of a part of a CAD model is defined to be another part of the same CAD model or a sub-part of a part of the same CAD model such that the former and the latter (the part and its pair) are always found in close proximity. The same concept may be extended to cover "groups of "triples" and larger groups of parts usually found together. One example of a type of CAD part that has a pair is a screw, where the pair of the screw is the boss. An example arrangement is shown in figure 4.

Assuming there is an existing detection procedure for a CAD part, the paired detection method may increase its accuracy by coupling the detection of the paired elements.

The flow of a paired detection method is shown in Figure 5. The method starts with detecting S50 all instances of the 1^{st} element in the pair (the screw in our screw-boss pair example) using an existing detection method for the 1^{st} element type. In parallel with the detection of the 1^{st} pair element, the system may also detect S60 the 2^{nd} pair element using an existing detection method for the 2^{nd} element type. (If there is a third element type it may also be detected at the same time, or the three elements may be detected at different times).

If any of the two pair elements are subparts instead of parts (that is, they are included in another part rather than being free-standing), a segmentation method may be applied as shown in Figure 6 to separate the element from the part to which it belongs. If the pair has not been found by using proximity of the two parts in S70, the 1^{st} element in S80 is rejected as false positive. Otherwise the pair is accepted in S90. Using the method described above, the expectation is that almost all of the false positives are automatically removed since the probability of a joint false positive is much smaller than that of an individual one.

If one of the elements of the pair is not a part but a sub-part of the CAD part (such as the boss in the screw-boss pair example) segmentation may be required to separate the feature from the rest of the part before applying the detection method. This process is described in Figure 6, which is an example of a segmentation process for detecting sub-parts of a part.

Firstly at the top left of the diagram, if the CAD model is stored in an analytic format, some pre-processing must first be performed in order to obtain CAD faces. This is not shown.

In the case the CAD model is stored in a triangulated format which stores face ID information, such as VRML, (see top centre of the diagram) then triangles that share the same face ID are grouped into CAD faces in S100.

If such information is not available (see top right of the diagram), the change in the angle of the normal of the triangles may be used in S110 to partition the surface into CAD faces (this may use a method similar to the "Reclasify 2D" function from the Gmsh meshing software of prior art document [2]).

Now that face information is available, characteristics of the face such as the dimensions of the bounding box or the area may be used to extract (in S120) the faces which are small enough to be part of a feature such as a boss. While the size threshold may vary with the application, for CAD models representing laptops it has been found that a suitable limit is to consider feature faces that have the largest dimension of the bounding box smaller than 2 cm. Removing faces larger than the chosen threshold from the set of faces helps with segmentation, since the larger faces which connect the features have now been removed.

Next, feature faces which have at least an edge (or one triangle edge for triangulated formats) in common are combined into "features" in S130. At this stage features which have less than N faces (for example N = 3) are disregarded since at least N individual faces are required to generate the type of feature that the process seeks to identify (e.g. the boss). This significantly reduces the number of features that need to be evaluated using machine learning.

Finally, each feature is taken in isolation and a similar method to the previously described screw detection is used to decide whether an individual feature is a boss or not. For example, one of the methods described in prior art documents [1] or [2]) may be used.

### Practical Example

Invention embodiments may be implemented as a computer program, written in C++. In a preferred implementation, the input data is not analytic CAD data but triangulated data with Face ID information (the middle path of Figure 6).

There are two main functions:
- A shape recognition function, which, given a subset of triangles from the original surface representing the shape to be detected, classifies the shape into screw/not-screw or boss/not-boss. This function uses machine learning to compare the shape to be classified to a database of existing shapes, using an algorithm similar to the one used in prior art document [2].
- A segmentation function, implemented following Figure 6, which reads the input mesh and outputs a number of mesh features that are then classified by the shape recognition function.

There is no special hardware requirement. In the particular case that the detection method uses deep learning, a Graphics Processing Unit GPU may greatly accelerate the computation.

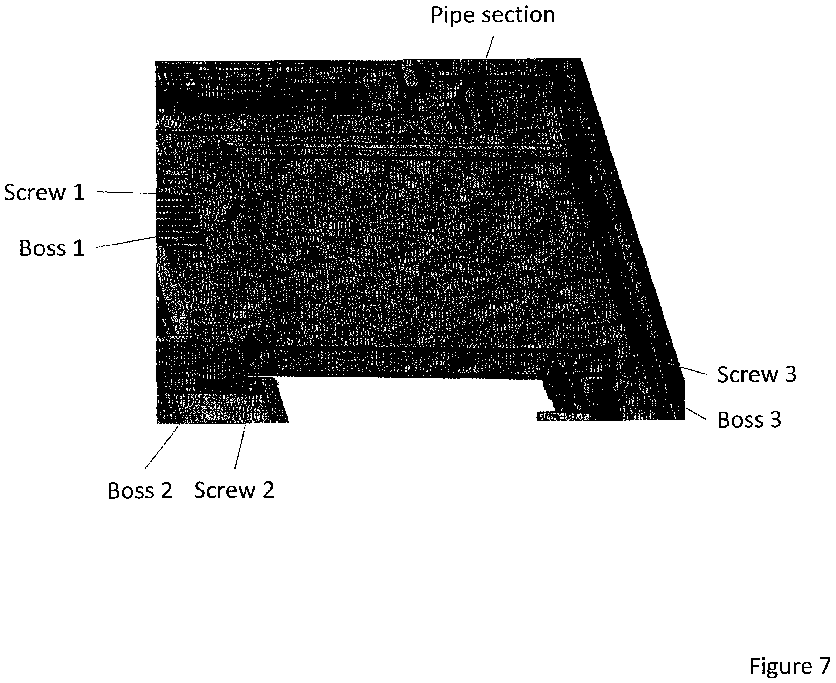

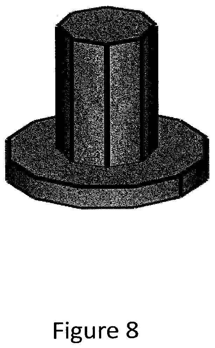

Consider the section of CAD model shown in figure 7, which contains 3 bosses, 3 screws and a pipe section. In this model, it is known that there is a screw for every boss, therefore the two form a pair. In the prior art, the way to detect the screws (the 1 st pair element) was by using the screw geometry alone, using methods known in the art. Such a geometry is shown in figure 8.

Shape based recognition, while quite accurate using state of the art methods, may never be expected to be perfect. Assume, for example, that the pipe segment from figure 7 could be mistaken for a screw.

In invention embodiments, to increase the detection accuracy, the problem is converted into a two-step process.

First, all screws in the model are detected using methods used in the prior art. It is assumed that the same issue is encountered as above and the shape recognition method recognizes as screws not only the 3 correct screws in the model but also the pipe segment.

In the second step another shape recognition task (including segmentation as described above) is performed and the 3 bosses are located. At this step it is also possible to make a mistake by mislabelling one or more additional CAD features as a boss.

Next the results of the two recognition tasks are combined. For screws no 1, 2 and 3, it is found that bosses 1, 2, 3, respectively, are in close proximity (i.e. their bounding boxes overlap) so they are accepted. Here "in close proximity" is defined in terms of bounding boxes. If the bounding boxes of the pair elements overlap within a certain tolerance, they are judged to be in close proximity. For an even more general condition, the distance between the two bounding boxes may be required to be below a certain threshold (in this case, overlap would always make this distance zero).

However, for the miss-classified pipe segment there is no corresponding boss in proximity, therefore it is rejected.

To summarize, the method of invention embodiments is able to reject the miss-classified pipe segment and as such to improve the accuracy of the original detection method.

This method, in the above formulation, may be applied only if the pair elements always appear together in the model. However, it may be extended to the case when element type 1 could make a pair with element type 2 or element type 3. In this case it is possible to detect all elements of types 2 and 3 and reject element type 1 if no type 2 or 3 element is present in close proximity. Alternatively, the different classifications of groups of elements (the screw/boss classification and the screw/nut classification for example) may be detected one after the next, so that an element rejected as not belonging to one classification of a group of elements might later be included within another classification. In this extension, groups of three elements should be treated first, if for example a third element (such as a washer) may or may not be present between a first and a second element. This is to prevent false positives of a pair of elements, when there is in fact a triple.

### Design issue detection for screw-boss pair

For the particular case in which the pair to detect is a screw-boss pair or another threaded pair, or a triplet including a threaded part, additional information may be automatically computed and provided to the users. This is because after the detection of a screw/boss pair and other such pairs and triplets has been successfully completed, placement information may be computed.

The following is an example of such placement information.

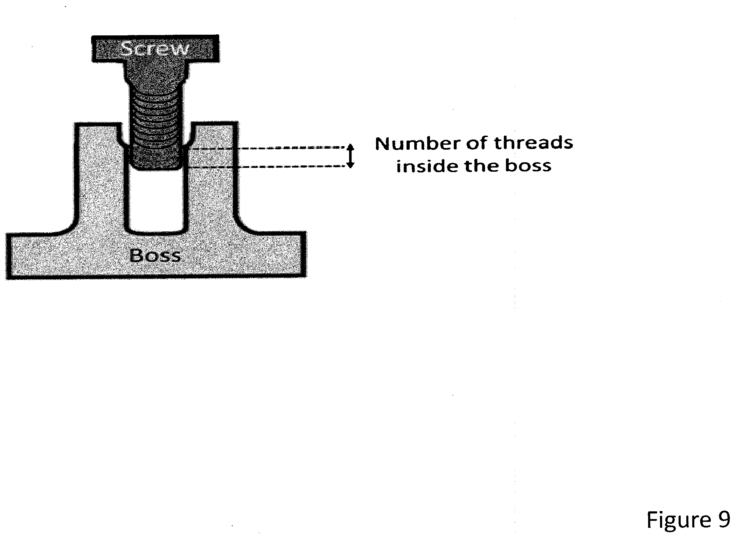

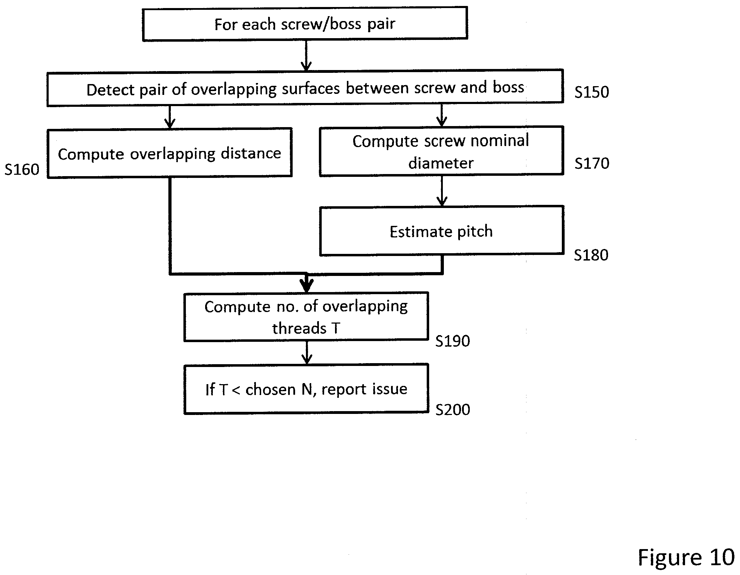

Here, for each detected pair of screw/boss, the penetration of the screw inside the boss is estimated. While this distance may be simply given to the user, in general it is more useful to provide the number of threads instead, as shown in figure 9 and as per the figure 10 flowchart. The threading itself is not necessarily modelled. The information available is the position of surfaces that define the interpenetration between the screw and the boss, for example the bottom of the screw and the top of the boss. Two such surfaces are detected in S150. The number of overlapping threads may be estimated using the: distance between these faces, computed in S160; the computed nominal diameter in S170; and the pitch estimated or calculated in S180, from the major diameter of the detected screw using the formula associated with the employed screw standard (in general the ISO metric screw thread standard or from the US threads per inch table). For example, if a nominal diameter of 3mm is computed it is assumed that this is an M3 type screw, which has a pitch of 0.5mm, hence 1 thread is assumed for each 0.5mm of detected interpenetration. Using a previously established threshold of N threads, an issue will be reported in S200 if the computed number of threads is less than N. An example of N used in practice is N=3 threads.

## Claims

1. A computer-implemented method of detecting a group of geometric features in a geometric model, the method comprising:
accessing a geometric model of an object with a group of geometric elements comprising at least a first and a second geometric element in a defined spatial relationship;
accessing detection results detecting any instances of each of the geometric elements;
checking that each instance of each geometric element has the defined spatial relationship with an instance of each of the other geometric elements;
when an instance of a geometric element does not have the defined spatial relationship with an instance of each of the other geometric elements, rejecting that instance of a geometric element as not belonging to the group.

2. A method according to claim 1 or 2, wherein the defined spatial relationship is that the distance between the geometric elements is below a threshold distance, or is a zero distance.

3. A method according to claim 3, wherein the distance between the geometrical elements is calculated by the distance between the centres of the geometrical elements, or by the distance between the bounding boxes of the geometrical elements.

4. A method according to claim 1, 2 or 3, wherein the group of geometric elements is a pair of elements comprising a screw element and one or more other elements, and is classified as comprising a screw and a boss, or a screw and a nut, or a screw and a washer.

5. A method according to claim 1, 2 or 3, wherein the group of geometric elements is a group of three elements comprising a screw and two or more other elements, and is classified as comprising a screw and a washer and a nut.

6. A method according to any of the preceding claims, wherein more than one classification of a group of elements is detected in a geometric model by detecting groups of each of a number of classifications.

7. A method according to any of the preceding claims, further including detecting the instances of the at least first and second geometric elements in parallel.

8. A method according to any of the preceding claims, further including segmenting the geometric model to detect subparts which potentially comprise an element of the group of elements.

9. A method according to claim 8, wherein subparts are detected by extracting faces below a predetermined size and combining the extracted faces into a possible element if they have an edge in common.

10. A method according to claim 8 or 9, wherein possible elements with less than a threshold minimum number of faces and/or more than a threshold maximum number of faces are disregarded.

11. A method according to any of the preceding claims, further comprising detecting penetration of a male element within a female element in the group, by detection of a surface of the male element and a surface of the female element which overlap and by computing the overlapping distance; and preferably wherein the overlapping distance is used to calculate a number of threads of interpenetration and to generate an alarm if the number of threads is less than a safe-threading threshold.

12. A method according to any of the preceding claims, wherein the geometric model comprises triangulated data with face information, or wherein the method includes production of triangulated data with face information.

13. A method according to any of the preceding claims, wherein the geometric model represents an assembly of physical parts.

14. A computer apparatus to detect a group of geometric features in a geometric model, the computer apparatus comprising:
a processor and a memory storing instructions for execution by the processor,
wherein the processor is configured by the instructions to:
access a computer file including a geometric model of an object with a group of geometric elements comprising at least a first and a second geometric element in a defined spatial relationship;
access detection results detecting any instances of each of the geometric elements;
check that each instance of each geometric element has the defined spatial relationship with an instance of each of the other geometric elements; and
when an instance of a geometric element does not have the defined spatial relationship with an instance of each of the other geometric elements, to reject that instance of a geometric element as not belonging to the group.

15. A computer program, which when executed carries out a computer-implemented method of detecting a group of geometric features in a geometric model according to any of the preceding method claims.
